Europäisches Patentamt

European Patent Office

Office européen des brevets

(19)

(11) Veröffentlichungsnummer : **0 346 738 B1**

# (12) EUROPÄISCHE PATENTSCHRIFT

(45) Veröffentlichungstag der Patentschrift :
08.04.92 Patentblatt 92/15

(51) Int. Cl.$^5$ : **C23C 16/50, H01J 37/32**

(21) Anmeldenummer : **89110224.6**

(22) Anmeldetag : **06.06.89**

(54) **Verfahren und Einrichtung zur PCVD-Innenbeschichtung metallischer Rohre mittels eines Mikrowellenplasmas.**

(30) Priorität : **14.06.88 DE 3820237**

(43) Veröffentlichungstag der Anmeldung :
20.12.89 Patentblatt 89/51

(45) Bekanntmachung des Hinweises auf die
Patenterteilung :
08.04.92 Patentblatt 92/15

(84) Benannte Vertragsstaaten :
**BE CH DE ES FR GB IT LI LU NL**

(56) Entgegenhaltungen :
**EP-A- 0 252 548**
**DE-A- 3 729 347**

(73) Patentinhaber : **Max-Planck-Gesellschaft zur
Förderung der Wissenschaften e.V.
Bunsenstrasse 10
W-3400 Göttingen (DE)**

(72) Erfinder : **Wilhelm, Rolf, Professor Dr.
Hürnbeckstrasse 10
W-8000 München 45 (DE)**

(74) Vertreter : **von Bezold, Dieter, Dr. et al
Dr. Dieter von Bezold Dipl.-Ing. Peter Schütz
Dipl.-Ing. Wolfgang Heusler Brienner Strasse
52
W-8000 München 2 (DE)**

EP 0 346 738 B1

**Beschreibung**

Die vorliegende Erfindung betrifft ein Mikrowellenplasmaverfahren zum Niederschlagen einer Schicht aus einem vorgegebenen Material auf der Innenfläche eines Rohres. Ferner betrifft die Erfindung eine Einrichtung zum Durchführen eines solchen Verfahrens.

Es ist bekannt, eine dünne Schicht aus einem vorgegebenen Material durch plasma-induziertes chemisches Niederschlagen aus der Gasphase, also mit Hilfe einer durch ein Plasma geförderten Reaktion einer dampfförmigen Verbindung zu erzeugen, die bei der Reaktion das betreffende Schichtmaterial liefert. Bei der chemischen Reaktion kann es sich um eine Reduktion, eine andere Reaktion oder auch nur um eine einfache Zersetzung handeln. Das Plasma wird bei den bekannten Verfahren dieser Art dadurch erzeugt, daß die Mikrowellen mittels eines Hornstrahlers oder dergleichen in eine mit einem Reaktionsgas gefüllte Kammer eingestrahlt werden, in der das zu beschichtende Substrat angeordnet ist. Für diese Verfahren hat sich der Begriff "PCVD-Verfahren" (Plasma-enhanced Chemical Vapor Deposition) eingebürgert. Es ist bei solchen Verfahren ferner bekannt, ein Plasma, das relativ niederenergetische Ionen enthält und daher eine das Substrat schonende Beschichtung ermöglicht, durch Einwirkung eines Magnetfeldes solcher Feldstärke, daß bei der Frequenz der Mikrowellen Elektronen-Zyklotronresonanz eintritt, zu erzeugen ("ECR-Verfahren"), siehe z. B DE-A-37 05 666 und Elektronik 22/30.10.1987, S. 136-138.

Der vorliegenden Erfindung liegt die Aufgabe zugrunde, ein Mikrowellenplasmaverfahren anzugeben, das eine Beschichtung des Inneren von langen, für Plasmen normalerweise nicht zugänglichen Rohren ermöglicht, die zumindest an der Innenfläche aus elektrisch leitfähigem Werkstoff, insbesondere Metall, bestehen.

Diese Aufgabe wird durch ein gattungsgemäßes Mikrowellenplasmaverfahren mit den kennzeichnenden Merkmalen des Anspruchs 1 gelöst.

Bei dem vorliegenden Verfahren zündet also eine im Rohr ausbreitungsfähige Mikrowelle durch Zyklotronresonanz lokal eine Plasmaentladung. Durch Bewegung des Magnetfeldes entlang der Rohrachse wird der Ort des Plasmas im Inneren des Rohres verschoben, sodaß eine über große Strecken homogene (oder ein gewünschtes Dickenprofil aufweisende) Plasmabeschichtung durchgeführt werden kann.

Das vorliegende Verfahren eignet sich hervorragend zur Innenbeschichtung von längeren Mikrowellenhohlleitern. Hohlleiter werden häufig mit einer Innenbeschichtung versehen, um die Durchschlagsfeldstärke bei hohen Mikrowellenleistungen durch Unterdrückung einer Sekundärelektronenemission zu verhindern.

Rohre für Fluide können mit einer Korrosionsschutz-Innenbeschichtung versehen werden.

Das vorliegende Verfahren eignet sich prinzipiell zur Herstellung aller Schichten, die auch durch konventionelle thermisch oder plasmainduzierte CVD-Verfahren hergestellt werden können, also z. B. Schichten aus keramischen Materialien, Carbiden wie TiC, TiN, SiC, $B_4C$, u.a.m.

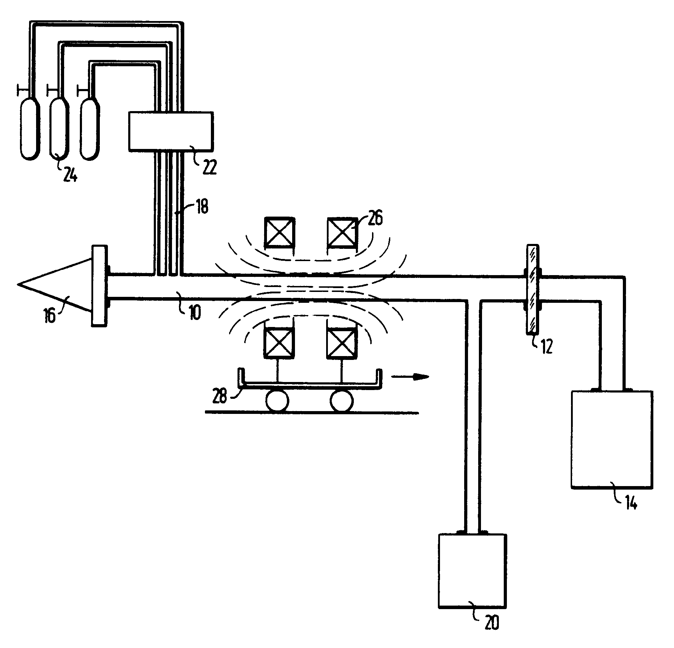

Im folgenden wird ein Ausführungsbeispiel der Erfindung unter Bezugnahme auf die Zeichnung näher erläutert, deren einzige Figur eine Einrichtung zur Innenbeschichtung eines Mikrowellenhohlleiters durch das Verfahren gemäß der Erfindung zeigt.

In der Zeichnung ist der Mikrowellenhohlleiter, dessen Innenwand zu beschichten ist, mit 10 bezeichnet. Der Mikrowellenhohlleiter kann die Form eines geraden, einige Meter langen Rohres mit rechteckigem Querschnitt haben. Ein Ende des Hohlleiters 10 ist über ein vakuumdichtes Fenster 12 mit einem Mikrowellengenerator 14 verbunden. An das andere Ende ist ein Mikrowellenabsorber 16 angeschlossen. Der Mikrowellenhohlleiter 10 ist ferner in der Nähe des absorberseitigen Endes mit einem Rohrleitungssystem 18 zum Einleiten von Reaktions- oder Arbeitsgasen und am fensterseitigen Ende mit einer Vakuumpumpe 20 verbunden. Das Rohrleitungssystem 18 ist über eine Vorrichtung 22 zur Durchflußregelung mit Arbeitsgasbehältern 24 verbunden. Der Hohlleiter 10 ist ferner mit einer Magnetspulenanordnung 26 umgeben, die zwei im Abstand voneinander angeordnete ringförmige Spulen enthält, die mit einer nicht dargestellten Gleichstromversorgung verbunden und durch eine Transportvorrichtung 28, wie einen Wagen, längs des Hohlleiters 10 verschiebbar sind.

Bei der Durchführung des vorliegenden Verfahrens werden die Arbeitsgase von den Behältern 24 über die Durchflußregeleinrichtung 22 in den Mikrowellenhohlleiter 10 eingespeist und durch die Pumpe 20 mit einer solchen Rate abgepumpt, daß sich in dem zu beschichtenden Bereich des Mikrowellenhohlleiters 10 ein geeigneter, niedriger Druck, insbesondere im der Größenordnung von Mikrobar, der eine Niederdruck-Gasentladung zuläßt, einstellt. Dann wird die Magnetspulenanordnung 28 eingeschaltet und schließlich wird der Mikrowellengenerator 24 in Betrieb gesetzt, um in den Hohlleiter Mikrowellenenergie einzuspeisen, die eine solche Frequenz hat, daß sie sich in Hohlleiter ausbreitet und schließlich im Absorber absorbiert wird, soweit sie nicht durch das Plasma verbraucht wurde.

Der Druck im Hohlleiter 10, die magnetische Feldstärke in einem lokalen Längsbereich des Hohlleiters sowie die Mikrowellenfrequenz und -leistung werden so gewählt, daß im Bereich des Magnetfeldes im Mikrowellenhohlleiter Elektronen-Zyklotronresonanz eintritt und dadurch dort eine lokale Niederdruckgasentladung zündet, die die das gewünschte Schichtmaterial liefernde Reaktion im Arbeitsgas auslöst. Die Magnetspulenanordnung 28 und damit die Plasmaentladung werden dann längs des Hohlleiters 10 verschoben, so daß die Beschichtungszone sich entsprechend verlagert und die Innenwand des Hohlleiters über die gewünschte Strecke beschichtet wird.

Die Gasdichte wird vorzugsweise so gewählt, daß die Stoßfrequenz der Elektronen deutlich niedriger ist als die Elektronen-Zyklotronfrequenz, d. h. die eingestrahlte Hochfrequenz.

Da die Gasentladung und dementsprechend das Niederschlagen der Schicht im wesentlichen nur im Bereich des für die Gasentladung notwendigen Magnetfeldess stattfindet, lassen sich der Ort und die Dicke des Niederschlages gut kontrollieren.

## Beispiel

Bei der Innenbeschichtung eines für 2,45 GHz bemessenen, 6 m langen Rechteckhohlleiters aus Kupfer wurde mit folgenden Parametern gearbeitet:
- Mikrowellenfrequenz: 2,45 GHz,
- Mikrowellenleistung am Ausgang des Generators: 5 kW,
- Lokale magnetische Feldstärke im Beschichtungsbereich: 0,087 T (870 Gauß),
- Gasdichte typisch einige Mikrobar.

## Patentansprüche

1. Mikrowellenplasmaverfahren zum Niederschlagen einer Schicht aus einem vorgegebenen Material auf einer Fläche mittels einer das vorgegebene Material liefernden Reaktion einer dampfförmigen Verbindung, bei welchem
a) vor der zu beschichtenden Fläche eine die dampfförmige Verbindung enthaltene Atmosphäre mit einem unter dem Atmosphärendruck liegenden Druck geschaffen wird,
b) im Bereich der zu beschichtenden Fläche ein Magnetfeld erzeugt wird, und
c) im Bereich der zu beschichtenden Fläche ein Hochfrequenzfeld erzeugt wird,
wobei der Druck, die Feldstärke des Magnetfeldes und die Frequenz sowie die Leistung des Hochfrequenzfeldes so gewählt sind, daß im Bereich des Magnetfelds Elektronen-Zyklotronresonanz eintritt und eine Niederdruck-Gasentladung entsteht, die die das vorgegebene Material liefernde Reaktion induziert **dadurch gekennzeichnet**, daß zur Innenbeschichtung eines Rohres, das zumindest an seiner Innenseite aus elektrisch leitfähigem Werkstoff, insbesondere aus Metall besteht, in das Rohr Mikrowellenenergie einer Frequenz eingespeist wird, die sich entlang des Rohres in diesem ausbreitet, und daß das Magnetfeld in einem örtlich begrenzten Längsbereich des Rohres erzeugt und in Längsrichtung des Rohres bewegt wird.

2. Verfahren nach Anspruch 1, **dadurch gekennzeichnet**, daß der Druck im Bereich der zu beschichtenden Oberfläche in der Größenordnung von Mikrobar gehalten wird.

3. Einrichtung zur Innenbeschichtung eines Rohres durch das Verfahren nach Anspruch 1, **gekennzeichnet durch**
- einen mit dem einen Ende des Rohres (10) gekoppelten Mikrowellengenerator (14),
- eine mit dem Rohr (10) verbundene Vorrichtung (22, 24) zum Einspeisen von Arbeitsgasen,
- eine mit dem Rohr verbundene Vakuumpumpe (20), und
- eine längs des Rohres (10) verschiebbare Vorrichtung (28) zum Erzeugen eines Magnetfeldes.

4. Einrichtung nach Anspruch 3, **gekennzeichnet durch** einen Mikrowellenabsorber (16), der mit dem dem Mikrowellengenerator abgewandten Ende des Rohres gekoppelt ist.

5. Einrichtung nach Anspruch 3, **gekennzeichnet durch** ein vakuumdichtes Fenster (12), das zwischen dem Mikrowellengenerator (14) und dem Rohr (10) angeordnet ist.

6. Einrichtung nach Anspruch 3, 4 oder 5, **dadurch gekennzeichnet**, daß das Rohr (10) ein Mikrowellenhohlleiter ist.

## Claims

1. Microwave plasma process for the deposition of a coating of a predetermined material on a surface by means of a reaction of a compound in vapour form, such reaction yielding the predetermined material, in which process
a) an atmosphere containing the compound in vapour form and at a pressure below atmospheric pressure is created in front of the surface for coating,

b) a magnetic field is generated in the area of the surface for coating and

c) a high-frequency field is generated in the area of the surface for coating,

the pressure, magnetic field strength and the frequency and power of the high-frequency field being so selected that electron cyclotron resonance occurs in the area of the magnetic field and a low-pressure gas-discharge forms which induces the reaction yielding the predetermined material, characterised in that for the purpose of internally coating a tube, at least the inside of which consists of electrically conductive material, more particularly metal, there is introduced into the tube microwave energy of a frequency which is propagated in and along the tube, and in that the magnetic field is generated in a locally limited longitudinal zone of the tube and is moved in the longitudinal direction of the tube.

2. A process according to claim 1, characterised in that the pressure is kept in the order of microbars in the area of the surface for coating.

3. Apparatus for the internal coating of a tube by the process according to claim 1, characterised by:

– a microwave generator (14) coupled to one end of the tube (10),

– a means (22, 24) connected to the tube (10) for the introduction of working gases,

– a vacuum pump (20) connected to the tube, and

– a means (24) movable along the tube (10) to generate a magnetic field.

4. Apparatus according to claim 3, characterised by a microwave absorber (16) coupled to that end of the tube which is remote from the microwave generator.

5. Apparatus according to claim 3, characterised by a vacuum-tight window (12) disposed between the microwave generator (14) and the tube (10).

6. Apparatus according to claim 3, 4 or 5, characterised in that the tube (10) is a hollow microwave guide.

## Revendications

1. Procédé à plasma micro-onde pour déposer sur une surface une couche d'un matière prédéterminée, au moyen d'une réaction d'un composé en phase vapeur fournissant la matière prédéterminée, procédé dans le cas duquel:

a) en amont de la surface à revêtir, on crée une atmosphère contenant le composé en phase vapeur sous une pression inférieure à la pression atmosphérique,

b) dans la zone de la surface à revêtir, on crée un champ magnétique, et

c) dans la zone de la surface à revêtir, on crée un champ à haute fréquence,

la pression, la puissance du champ magnétique, et la fréquence et la puissance du champ à haute fréquence, étant choisies de telle façon que, dans la zone du champ magnétique, il se produise une résonance gyromagnétique et une décharge de gaz basse pression, qui induit la réaction fournissant la matière prédéterminée, caractérisé en ce que, pour revêtir l'intérieur d'un tube, qui, au moins sur sa face interne, est constitué de matière conductrice de l'électricité, en particulier de métal, on envoie dans le tube une énergie à micro-ondes d'une certaine fréquence, qui se répartit tout au long du tube, et en ce qu'on crée le champ magnétique dans une zone limitée, localisée le long du tube, et on le déplace suivant la direction longitudinale du tube.

2. Procédé suivant la revendication 1, caractérisé en ce qu'on maintient, dans la zone de la surface à revêtir, une pression de l'ordre de grandeur du microbar.

3. Dispositif pour revêtir l'intérieur d'un tube au moyen du procédé de la revendication 1, caractérisé par

– un générateur de micro-ondes (14) ajusté à une extrémité du tube (10),

– un dispositif (22, 24), relié au tube (10), pour l'alimentation en gaz de traitement,

– une pompe à vide (20) raccordée au tube, et

– un dispositif (28) pouvant se déplacer le long du tube (10) pour réaliser un champ magnétique.

4. Dispositif suivant la revendication 3, caractérisé par un absorbeur (16) de micro-ondes, qui est ajusté à l'extrémité du tube située du côté opposé au générateur de micro-ondes.

5. Dispositif suivant la revendication 3, caractérisé par une fenêtre (12), étanche au vide, qui est disposée entre le générateur de micro-ondes (14) et le tube (10).

6. Dispositif suivant la revendication 3, la revendication 4 ou la revendication 5, caractérisé en ce que le tube (10) est un conducteur creux de guidage de microondes.

EP 0 346 738 B1